# EUROPÄISCHE PATENTANMELDUNG

(11) **EP 3 035 528 A1**
(43) Veröffentlichungstag der Anmeldung: **22.06.2016**
(21) Anmeldenummer: 14199336.0
(22) Anmeldetag: 19.12.2014
(51) Int. Cl.: H03F 3/387, H03F 3/45, H03F 3/393, H03M 3/00, H03M 3/02

(54) **Anordnung zur Kompensation einer Offset-Spannung und Verfahren**

(71) Anmelder: Siemens Aktiengesellschaft, 80333 München (DE)
(72) Erfinder: Prochaska, Dirk, 09127 Chemnitz (DE)

(57) **Zusammenfassung**

Die Erfindung betrifft eine Anordnung (1) zur Kompensation einer Offset-Spannung (U_{off}) eines elektronischen Verstärkers (2), umfassend
- einen elektronischen Verstärker (2) mit einem ersten Eingang (E+), einem zweiten Eingang (E-), einem ersten Ausgang (A+) und einem zweiten Ausgang (A-),
- einem Eingangsschaltmittel (10),
- einem Ausgangsschaltmittel (20),
- einer Steuerschaltung (30),

wobei die Eingangsschaltmittel (10) derart zwischen einem Signaleingang (X) und dem ersten Eingang (E+) und dem zweiten Eingang (E-) angeordnet sind, dass in einem ersten Schaltzustand (Z1) der erste Eingang (E+) mit dem Signaleingang (X) verbunden ist und in einem zweiten Schaltzustand (Z2) der zweite Eingang (E-) mit dem Signaleingang (X) verbunden ist, und wobei die Ausgangsschaltmittel (20) derart zwischen einem Signalausgang (Y) angeordnet sind, dass in dem ersten Schaltzustand (Z1) der erste Ausgang (A+) mit dem Signalausgang (Y) verbunden ist und in dem zweiten Schaltzustand (Z2) der zweite Ausgang (A-) mit dem Signalausgang (Y) verbunden ist, und wobei die Steuerschaltung (30) ausgestaltet ist das Eingangsschaltmittel (10) und das Ausgangsschaltmittel (20) synchron in den ersten Schaltzustand (Z1) bzw. in den zweiten Schaltzustand (Z2) zu schalten.

## Beschreibung

Die Erfindung betrifft eine Anordnung zur Kompensation einer Offset-Spannung eines elektronischen Verstärkers, umfassend einen elektronischen Verstärker mit einem ersten Eingang, einem zweiten Eingang, einem ersten Ausgang und einem zweiten Ausgang, einem Eingangsschaltmittel, einem Ausgangsschaltmittel, einer Steuerschaltung, wobei die Eingangsschaltmittel derart zwischen einem Signaleingang X und dem ersten Eingang und dem zweiten Eingang angeordnet sind, dass in einem ersten Schaltzustand der erste Eingang mit dem Signaleingang verbunden ist und in einem zweiten Schaltzustand der zweite Eingang mit dem Signaleingang verbunden ist, und wobei die Ausgangsschaltmittel derart zwischen einem Signalausgang angeordnet sind, dass in dem ersten Schaltzustand der erste Ausgang mit dem Signalausgang verbunden ist und in dem zweiten Schaltzustand der zweite Ausgang mit dem Signalausgang verbunden ist, und wobei die Steuerschaltung ausgestaltet ist, das Eingangsschaltmittel und das Ausgangsschaltmittel synchron in den ersten Schaltzustand bzw. in den zweiten Schaltzustand zu schalten.

Bei elektronischen Verstärkern, insbesondere bei Operationsverstärkern oder Komparatoren, macht sich eine Offset-Spannung in einem zu ermittelnden Endergebnis in der Regel störend bemerkbar. Die bei Operationsverstärkern und Komparatoren entstehenden Offset-Fehler führen letztendlich zu Messfehlern bei Anordnungen, welche diese Bauteile enthalten.

Als Offset-Spannung bezeichnet man beispielsweise die Ausgangsspannung, die sich einstellt, wenn die Eingänge eines Operationsverstärkers kurzgeschlossen werden. Die Offset-Spannung ist als Fehlergröße beim Schaltungsdesign zu berücksichtigen. Vereinfachend kann man sich die Offset-Spannung vorstellen als eine zusätzliche Spannungsquelle, die beispielsweise bei einem Operationsverstärker-Eingang in Reihe geschaltet ist und somit zum Eingangssignal addiert wird. Dieser aufaddierte Offset-Fehler ist zum einen temperatur-und zum anderen pegelabhängig. Will man heutzutage genaue Messungen erzielen, muss aus diesem Grund auf eine reine Gleichstromverstärkung verzichtet werden und nur auf eine Wechselspannungsverstärkung zurückgegriffen werden. Diese Wechselspannungsverstärker werden nach dem Stand der Technik in Form von Chopper-Verstärkern realisiert. Gleichspannungen werden dazu vorher in Wechselspannungen zerhakt und nach dem Verstärken wieder zusammengesetzt. Der eigentliche Verstärker ist dabei durch eine gleichspannungsfreie Kopplung über Kondensatoren gekennzeichnet.

Nachteilig an dem bisher bekannten Verfahren ist es, dass teure und langsame Chopper-Verstärker benutzt werden müssen. Sind die Anforderungen an die Messfehlern nicht allzu hoch, können auch gebräuchliche Kalibrierverfahren genutzt werden. Auch werden beispielsweise gleichartige Verstärker unter ähnlichen Umweltbedingungen betrieben, einer dieser Verstärker ist bei der Messung aktiv und am zweiten Verstärker wird ohne ein Eingangssignal die Offset-Spannung gemessen und nachher bei dem ersten Verstärker vom Messergebnis wieder abgezogen.

Es ist Aufgabe der vorliegenden Erfindung eine Anordnung zur Kompensation einer Offset-Spannung eines elektronischen Verstärkers bereitzustellen, bei welcher auf zusätzliche Chopper-Verstärker verzichtet werden kann.

Die Aufgabe wird für die eingangs genannte Anordnung, insbesondere dadurch gelöst, dass ein Mess-Signal einmal phasenrichtig und einmal phasengewendet dem Verstärker zugeführt wird, wobei zusätzlich zum Ausgang des Verstärkers das phasengewendete Signal synchron wieder in Phase mit dem Mess-Signal gebracht wird. Dazu verfügt die Anordnung über Eingangsschaltmittel, welche derart zwischen einem Signaleingang für das Mess-Signal und dem ersten Eingang und dem zweiten Eingang angeordnet sind, dass in einem ersten Schaltzustand der erste Eingang mit dem Signaleingang verbunden ist und in einem zweiten Schaltzustand der zweite Eingang mit dem Signaleingang verbunden ist. Um diese künstlich hervorgerufene Phasendrehung wieder rückgängig zu machen, sind die Ausgangsschaltmittel derart zwischen einem Signalausgang angeordnet, das in dem ersten Schaltzustand der erste Ausgang mit dem Signalausgang verbunden ist und in dem zweiten Schaltzustand der zweite Ausgang mit dem Signalausgang verbunden ist, und wobei die Steuerschaltung ausgestaltet ist, das Eingangsschaltmittel und das Ausgangsschaltmittel synchron in den ersten Schaltzustand bzw. in den zweiten Schaltzustand zu schalten. Diese Anordnung ist vorteilhaft, bei allen elektronischen Schaltungen bei denen sich ein Offset-Fehler störend bemerkbar macht.

In einer ersten Ausgestaltungsvariante der Erfindung ist der elektronische Verstärker als ein Operationsverstärker ausgebildet. In einer zweiten Ausgestaltungsvariante der Erfindung ist der elektronische Verstärker als ein Sigma-Delta-Modulator ausgestaltet. Die aufgezeigte Anordnung und ein späteres Verfahren eignen sich besonders für einen Komparatorteil von Sigma-Delta-Analog-Digital-Wandlern. Da hier ein digitales Ausgangssignal erzeugt wird. Dadurch, dass man dem Komparator eines Sigma-Delta-Wandlers ein Mess-Signal einmal phasenrichtig und einmal phasengewendet zuführt und anschließend am Ausgang des Komparators das phasengewendete Signal synchron wieder in Phase mit den zugeführten Mess-Signal bringt, erhält man zum einen ein Mess-Signal plus die Offset-Spannung und zum anderen ein Mess-Signal minus die Offsetspannung, wobei durch anschließende Addition oder auch durch eine Integration über die beiden zeitlich hintereinander folgenden Signale die Offset-Spannung kompensiert werden kann.

Insbesondere für den Einsatz eines Sigma-Delta-Modulators für eine Analog-Digital-Wandlung ist es von Vorteil, wenn der Sigma-Delta-Modulator einen Komparator, einen 1-Bit-Speicher und einen Integrator aufweist, der Komparator verfügt über einen nicht invertierenden Eingang, welcher mit dem ersten Eingang verbunden ist und einem invertierenden Eingang, welcher mit dem zweiten Eingang verbunden ist, weiterhin verfügt der Komparator über einen Komparatorausgang, welcher mit einem Dateneingang des 1-Bit-Speichers verbunden ist, der 1-Bit-Speicher, besitzt einen ersten Speicherausgang, welcher mit dem ersten Ausgang verbunden ist und einem zweiten Speicherausgang, welcher mit dem zweiten Ausgang verbunden ist, der Integrator ist mit einem Integratoreingang an dem Signalausgang und mit einem Integratorausgang an das Eingangsschaltmittel angeschlossen, wobei das Eingangsschaltmittel weiterhin ausgestaltet ist, in den ersten Schaltzustand den Integratorausgang mit dem zweiten Eingang und in den zweiten Schaltzustand mit dem ersten Eingang zu verbinden. Das Eingangsschaltmittel ist dabei vorzugsweise als ein zweifacher Wechselschalter ausgestaltet, wobei die Wechselschaltung zwischen dem Anschalten eines Mess-Signals und dem Anschalten an ein Vergleichssignal, welches für den Sigma-Delta-Modulator notwendig ist, hin und her schaltet.

Die eingangs genannte Aufgabe wird ebenso gelöst durch ein Verfahren zur Kompensation einer Offset-Spannung einer Anordnung mit einem elektronischen Verstärker nach einem der Ansprüche 1 bis 4. Dazu wird verfahrensgemäß ein Mess-Signal dem Signaleingang zugeführt und das Eingangsschaltmittel über die Steuerschaltung taktgesteuert, wobei durch das Mess-Signal im ersten Schaltzustand dem ersten Eingang und dem zweiten Schaltzustand dem zweiten Eingang zugeführt wird, wodurch an dem ersten Ausgang und an dem zweiten Ausgang im Bezug auf eine Phasenlage des Mess-Signals alternierend eine Phasendrehung entsteht, um diese Phasendrehung wieder aufzuheben, steuert die Steuerschaltung das Ausgangsschaltmittel derart, dass taktsynchron der erste Ausgang bzw. der zweite Ausgang mit dem Signalausgang verbunden wird, wodurch die Offset-Spannung kompensiert wird.

Insbesondere bei einem Verfahren für eine Analog-Digital-Wandlung, wird als elektronischer Verstärker ein Sigma-Delta-Modulator genutzt. Bei dem Verfahren zur Analog-Digital-Wandlung wird das Mess-Signal alternierend einmal dem nicht invertierenden Eingang und einmal dem invertierenden Eingang des Komparators zugeführt, wobei ein an dem Komparatorausgang herrschendes bitserielles Signal dem 1-Bit-Speicher zugeführt wird und die Speicherausgänge werden über das Ausgangsschaltmittel ebenfalls alternierend mit dem Signalausgang verbunden, wodurch nach einer Integration der am Signalausgang anliegenden Spannung die Offset-Spannung kompensiert wird.

Es hat sich gezeigt, dass im Hinblick auf eine Genauigkeit zu erzielender Messergebnisse, es von besonderem Vorteil ist, dass für die Steuerschaltung eine Periodendauer des Taktsignals so gewählt wird, dass eine Änderung in der Amplitude des Mess-Signals während der Zeitdauer der Periodendauer nahezu Null ist.

Die Zeichnung zeigt ein Ausführungsbeispiel. Es zeigt die
- FIG 1: eine erste Ausgestaltungsvariante mit einem Operationsverstärker,
- FIG 2: eine zweite Ausgestaltungsvariante mit einem Sigma-Delta-Modulator und
- FIG 3: Spannungsverläufe einer Simulation um das Prinzip der Phasenumkehr mit einer positiven Offset-Spannung und einer negativen Offset-Spannung zu erläutern.

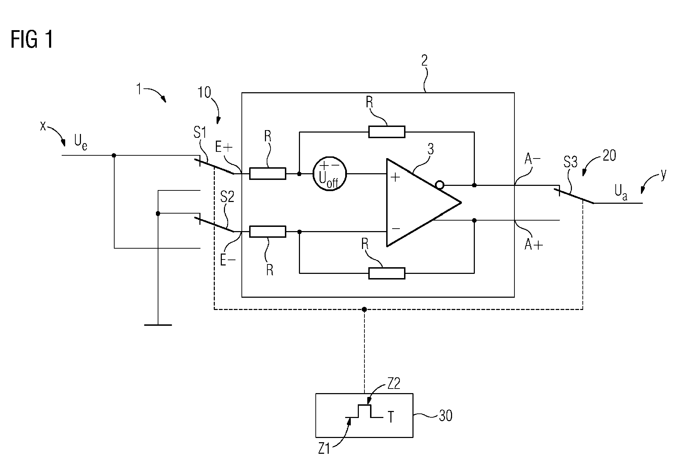

Gemäß FIG 1 ist eine Anordnung 1 zur Kompensation einer Offset-Spannung U_{off} eines elektronischen Verstärkers 2 dargestellt. Der elektronische Verstärker 2 ist als ein Operationsverstärker 3 ausgestaltet. An einen nicht invertierenden Eingang + des Operationsverstärkers 3 und an einen invertierenden Eingang - des Operationsverstärkers 3 wird jeweils über einen Vorwiderstand R ein Schalter S1 bzw. ein Schalter S2 des Eingangsschaltmittels 10 angeschlossen. Die Schalter S1,S2 des Eingangsschaltmittels 10 sind derart ausgestaltet und angeschlossen, dass sie zwischen der Zuführung eines Mess-Signals Uₑ und einer Masseankopplung hin- und herschalten können. Der elektronische Verstärker 2 weist als Signaleingang X eine Leitung auf, welche zweigeteilt wird und jeweils an die Wechselkontakte des ersten Schalters S1 bzw. an die Wechselkontakte des zweiten Schalters S2 geführt wird.

In Verbindung mit einer Steuerschaltung 30 wird das Eingangsschaltmittel 10 mit seinem ersten Schalter S1 und seinem zweiten Schalter S2 derart gesteuert, dass in einem ersten Schaltzustand Z1 der erste Eingang E+ mit dem Signaleingang X verbunden ist und in einem zweiten Schaltzustand Z2 der zweite Eingang E- mit dem Signaleingang X verbunden ist.

Zeitgleich zur Steuerung des Eingangsschaltmittels 10 wird ein Ausgangsschaltmittel 20 derart gesteuert, dass in dem ersten Schaltzustand Z1 der erste Ausgang A+ mit einem Signalausgang Y verbunden ist und in dem zweiten Schaltzustand Z2 der zweite Ausgang A- mit dem Signalausgang Y verbunden ist. Die Steuerschaltung 30 ist dabei ausgestaltet, dass Eingangsschaltmittel 10 und Ausgangsschaltmittel 20 synchron in den ersten Schaltzustand Z1 bzw. in den zweiten Schaltzustand Z2 zu schalten. Das Ausgangsschaltmittel 20 weist einen dritten Schalter S3 auf, welcher ebenfalls als ein Wechselschalter ausgestaltet ist, und zwischen einem invertierenden Ausgang und einen nicht invertierenden Ausgang hin- und herschaltet. Addiert man diese aufeinanderfolgenden Signale, kompensiert sich die Offsetspannung U_{off}. Eine Integration über die zeitlich hintereinanderfolgenden Ausgangssignale wäre neben anderen Verfahren auch möglich.

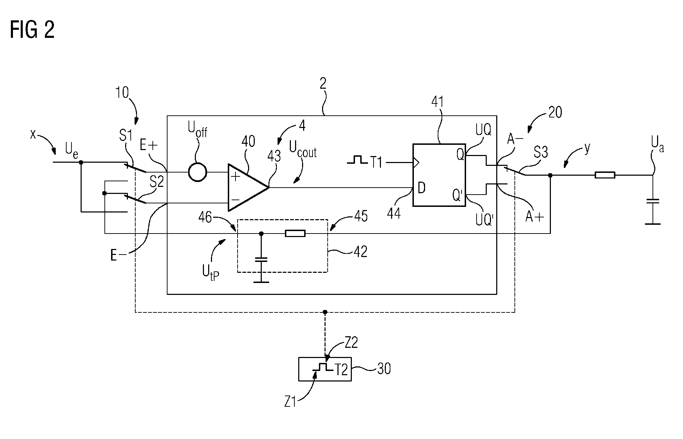

Die FIG 2 verdeutlicht die zweite Alternative der Ausgestaltung, wobei der elektronische Verstärker 2 als ein Sigma-Delta-Modulator 4 ausgestaltet ist. Die Anordnung 1 gemäß FIG 2 und die Anwendung eines Verfahrens dafür empfehlen sich, insbesondere für den Komparatorteil von Sigma-Delta-Modulatoren bzw. ganzen Sigma-Delta-Analog-Digital-Wandlern. Hierzu weist der Sigma-Delta-Modulator 4 einen Komparator 40, einen 1-Bit-Speicher 41 und einen Integrator 42 auf. Der Komparator 40 verfügt über einen nicht invertierenden Eingang +, welcher über einen ersten Eingang E+ verbunden ist, und über einen invertierenden Eingang -, welcher mit den zweiten Eingang E-verbunden ist. Weiterhin verfügt der Komparator 40 über einen Komparatorausgang 43, welcher mit einem Dateneingang 44 des 1-Bit-Speichers 41 verbunden ist, der 1-Bit-Speicher 41 besitzt einen ersten Speicherausgang Q, welcher mit dem ersten Ausgang A+ verbunden ist, und einen zweiten Speicherausgang Q', welcher mit dem zweiten Ausgang A- verbunden ist. Der Integrator 42 ist mit einem Integratoreingang 45 an den Signalausgang Y und mit einem Integratorausgang 46 an das Eingangsschaltmittel 10 angeschlossen, wobei das Eingangsschaltmittel 10 weiterhin ausgestaltet ist, in dem ersten Schaltzustand Z1 den Integratorausgang 46 mit dem zweiten Eingang E- und in den zweiten Schaltzustand Z2 mit dem ersten Eingang E+ zu verbinden.

Der 1-Bit-Speicher 41 wird über einen Takteingang mit einem ersten Takt T1 versorgt. Der 1-Bit-Speicher ist dabei als ein D-Flipflop ausgestaltet und schaltet mit jedem Taktsignal des erstes Taktes T1 seine Speicherausgänge Q,Q' um, wodurch ein bitserielles Signal erzeugt wird.

Die Steuerschaltung 30 schaltet die Eingangsschaltmittel 10 und die Ausgangsschaltmittel 20 mit einem zweiten Takt T2 hin und her.

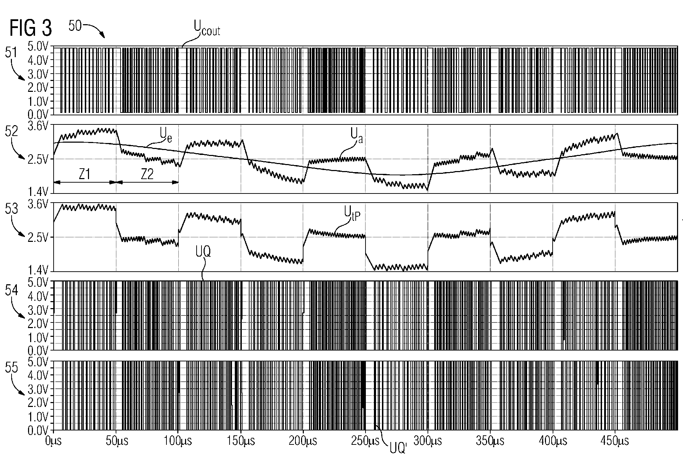

Zur Verdeutlichung der Kompensation der Offset-Spannung U_{off} bzw. des negativen Anteils der Offset-Spannung U_{off} und des positiven Anteils der Offset-Spannung U_{off} sind mit der FIG 3 Spannungsverläufe 50 einer Simulation dargestellt. Im Einzelnen zeigt ein erstes Spannungsdiagramm 51 eine Komparatorausgangsspannung U_{Cout}, ein zweites Diagramm 52 das Mess-Signal Uₑ und eine Ausgangs-Spannung Uₐ am Ausgang Y, ein drittes Spannungsdiagramm 53 eine Spannung Uₜₚ nach dem Integrator 42 am Integratorausgang 46, ein viertes Spannungsdiagramm 54 die Spannung U_{Q} am ersten Speicherausgang Q und ein fünftes Spannungsdiagramm 55 die Spannung U_{Q'} am zweiten Speicherausgang Q'.

Die Spannung am Komparatorausgang U_{Cout} stellt einen Bit-Strom dar, wie er typisch ist für einen Sigma-Delta-Modulator 4. Das zweite Spannungsdiagramm 52 verdeutlicht das Ausgangssignal Uₐ, wobei sich die Offset-Spannung U_{off} mit plus Offset und minus Offset um das Mess-Signal Uₑ bewegt, woraus letztendlich eine Kompensation hergeleitet werden kann. Die Darstellungen dienen nur dem Verständnis, bei einem reellen Offset und ausreichend hoher Schaltfrequenz könnte das Prinzip nicht dargestellt werden. Um das Prinzip einer reellen Anwendung durchzuführen, muss die Steuerschaltung 30 eine Periodendauer des Taktsignals bereitstellen, welche derart gewählt ist, dass eine Änderung in der Amplitude des Mess-Signals Uₑ nahezu Null ist, welches bedeutet, die Schaltfrequenz zum Schalten der Eingangsschaltmittel 10 bzw. der Ausgangsschaltmittel 20 muss wesentlich höher sein, als die Frequenz des Mess-Signals Uₑ.

Das dritte Spannungsdiagramm 53 stellt die Spannung Uₜₚ als eine Vergleichsspannung am Integratorausgang 46 dar. Auch die Vergleichsspannung Uₜₚ wird über die Schalter S1,S2 wechselseitig einmal dem ersten Eingang E+ und einmal dem zweiten Eingang E- zugeführt, um das Sigma-Delta-Prinzip zu erreichen.

Mit dem vierten Spannungsdiagramm 54 und dem fünften Spannungsdiagramm 55 sind die Spannungsverläufe als Bit-Strom am ersten Speicherausgang Q bzw. am zweiten Speicherausgang Q' dargestellt.

Demnach steht nach dem ausgangsseitigen Ausgangsschaltmittel 20 ein Digitalsignal, insbesondere ein digitaler Datenstrom, zur Weiterverarbeitung zur Verfügung, dem das alternierende Offset-Signal überlagert ist. Das Offset-Signal kann durch Integration (Tiefpass) oder taktversetzte Addition oder auch durch einen Digital-Filter wieder entfernt werden und ist damit kompensiert.

Als besonders vorteilhaft wird angesehen, dass durch die Umschaltung zwischen einer Invertierung und einer nicht Invertierung eine Kompensation der Offset-Spannung U_{off} auf eine einfache Art und Weise realisiert werden kann. Das Verfahren ist sowohl für reine Analogschaltungen als auch für A/D-Wandler, im Beispiel der Sigma-Delta-Wandler, anwendbar und damit recht allgemein gültig. Weiterhin wird als vorteilhaft angesehen, dass insbesondere die Ausgangsschaltmittel und das im Beispiel gezeigte D-FlipFlop einfach in eine digitale Schaltungstechnik integriert werden können. Amplitudenfehler durch Schalterwiderstände, beispielsweise von FET's, spielen dabei keine Rolle, da es sich hier um digitale Signale handelt. Die ohmschen Widerstände in den eingangsseitigen Umschaltern haben ebenfalls wenig Einfluss, da sie praktisch keine Leistung schalten.

Zusammenfassend kann gesagt werden, dass wenn ein Mess-Signal einmal dem nicht invertierenden Eingang und einmal dem invertierenden Eingang zugeführt wird, so erhält man das Mess-Signal einmal phasenrichtig und einmal phasengewendet. An der Offset-Spannung bzw. an dem Betrag der Offset-Spannung ändert sich dabei nichts, dieser überraschende Effekt kann zu Kompensation der Offset-Spannung benutzt werden. Hierzu sollte man lediglich die zeitlich aufeinanderfolgenden Signale addieren.

## Patentansprüche

1. Anordnung (1) zur Kompensation einer Offset-Spannung (U_{off}) eines elektronischen Verstärkers (2), umfassend
- einen elektronischen Verstärker (2) mit einem ersten Eingang (E+), einem zweiten Eingang (E-), einem ersten Ausgang (A+) und einem zweiten Ausgang (A-),
- einem Eingangsschaltmittel (10),
- einem Ausgangsschaltmittel (20),
- einer Steuerschaltung (30),
wobei die Eingangsschaltmittel (10) derart zwischen einem Signaleingang (X) und dem ersten Eingang (E+) und dem zweiten Eingang (E-) angeordnet sind, dass in einem ersten Schaltzustand (Z1) der erste Eingang (E+) mit dem Signaleingang (X) verbunden ist und in einem zweiten Schaltzustand (Z2) der zweite Eingang (E-) mit dem Signaleingang (X) verbunden ist, und
wobei die Ausgangsschaltmittel (20) derart zwischen einem Signalausgang (Y) angeordnet sind, dass in dem ersten Schaltzustand (Z1) der erste Ausgang (A+) mit dem Signalausgang (Y) verbunden ist und in dem zweiten Schaltzustand (Z2) der zweite Ausgang (A-) mit dem Signalausgang (Y) verbunden ist, und wobei die Steuerschaltung (30) ausgestaltet ist das Eingangsschaltmittel (10) und das Ausgangsschaltmittel (20) synchron in den ersten Schaltzustand (Z1) bzw. in den zweiten Schaltzustand (Z2) zu schalten.

2. Anordnung (1) nach Anspruch 1, wobei der elektronische Verstärker (2) als ein Operationsverstärker (3) ausgestaltet ist.

3. Anordnung (1) nach Anspruch 1, wobei der elektronische Verstärker (2) als ein Sigma-Delta-Modulator (4) ausgestaltet ist.

4. Anordnung (1) nach Anspruch 3, wobei der Sigma-Delta-Modulator (4) einen Komparator (40), einen 1-Bit-Speicher (41) und einen Integrator (42) aufweist, der Komparator (40) verfügt über einen nicht invertierenden Eingang (+), welcher mit dem ersten Eingang (E+) verbunden ist, und einen invertierenden Eingang (-), welcher mit dem zweiten Eingang (E-) verbunden ist, weiterhin verfügt der Komparator (40) über einen Komparatorausgang (43), welcher mit einem Dateneingang (44) des 1-Bit-Speichers (41) verbunden ist, der 1-Bit-Speicher (41) besitzt einen ersten Speicherausgang (Q), welcher mit dem ersten Ausgang (A+) verbunden ist, und einen zweiten Speicherausgang (Q'), welcher mit dem zweiten Ausgang (A-) verbunden ist, der Integrator (42) ist mit einem Integratoreingang (43) an den Signalausgang (Y) und mit einem Integratorausgang (44) an das Eingangsschaltmittel (10) angeschlossen, wobei das Eingangsschaltmittel (10) weiterhin ausgestaltet ist in dem ersten Schaltzustand (Z1) den Integratorausgang (46) mit dem zweiten Eingang (E-) und in dem zweiten Schaltzustand (Z2) mit dem ersten Eingang (E+) zu verbinden.

5. Verfahren zur Kompensation einer Offset-Spannung (U_{off}) einer Anordnung (1) mit einem elektronischen Verstärker (2) nach einem der Ansprüche 1 bis 4, wobei ein Mess-Signal (Uₑ) dem Signaleingang (X) zugeführt wird und das Eingangsschaltmittel (10) über die Steuerschaltung (30) taktgesteuert wird, wobei das Mess-Signal (Uₑ) im ersten Schaltzustand (Z1) dem ersten Eingang (E+) und im zweiten Schaltzustand (Z2) dem zweiten Eingang (E-) zugeführt wird, wodurch an dem ersten Ausgang (A+) und an dem zweiten Ausgang (A-) im Bezug auf eine Phasenlage des Mess-Signals (Uₑ) alternierend eine Phasendrehung entsteht, um diese Phasendrehung wieder aufzuheben, steuert die Steuerschaltung (30) das Ausgangsschaltmittel (20) derart das taktsynchron der erste Ausgang (A+) bzw. der zweite Ausgang (A-) mit dem Signalausgang (Y) verbunden wird, wodurch die Offset-Spannung (U_{off}) kompensiert wird.

6. Verfahren nach Anspruch 5, wobei der elektronische Verstärker (2) als ein Sigma-Delta-Modulator (4) genutzt wird, dazu wird das Mess-Signal (Uₑ) alternierend einmal dem nicht invertierenden Eingang (+) und einmal dem invertierenden Eingang (-) des Komparators (40) zugeführt, wobei ein an dem Komparatorausgang (43) herrschendes bitserielles Signal dem 1-Bit-Speicher (41) zugeführt wird und die Speicherausgänge (Q, Q') werden über das Ausgangsschaltmittel (20) ebenfalls alternierend mit dem Signalausgang (Y) verbunden, wodurch nach einer Integration der am Signalausgang (Y) anliegenden Spannung die Offset-Spannung kompensiert wird.

7. Verfahren nach Anspruch 5 oder 6, wobei für die Steuerschaltung (30) eine Periodendauer des Taktsignals so gewählt wird, dass eine Änderung in der Amplitude des Mess-Signals (Uₑ) während der Zeitdauer der Periodendauer nahezu Null ist.
